Europäisches Patentamt

European Patent Office

Office européen des brevets

(11) Publication number: **0 427 640 A1**

# EUROPEAN PATENT APPLICATION

(21) Application number: 90403197.8

(51) Int. Cl.5: **H01L 39/22**, H01L 39/24

(22) Date of filing: **09.11.90**

(30) Priority: **10.11.89 JP 292987/89**

(43) Date of publication of application:
**15.05.91 Bulletin 91/20**

(84) Designated Contracting States:
**CH DE FR GB IT LI NL**

(71) Applicant: **SUMITOMO ELECTRIC INDUSTRIES, LTD.**
**5-33, Kitahama 4-chome, Chuo-ku**
**Osaka-shi, Osaka 541(JP)**

(72) Inventor: **Higaki, Kenjiro, c/o Itami Works of Sumitomo Elec.**
**Ind. Ltd., 1-1 Koyakita 1-chome**
**Itami-shi, Hyogo(JP)**
Inventor: **Matsuura, Takashi, c/o Itami Works of Sumitomo Ele**
**Ind. Ltd., 1-1 Koyakita 1-chome**

**Itami-shi, Hyogo(JP)**
Inventor: **Tanaka, Saburo, c/o Itami Works of Sumitomo Ele**
**Ind. Ltd., 1-1 Koyakita 1-chome**
**Itami-shi, Hyogo(JP)**
Inventor: **Itozaki, Hideo, c/o Itami Works of Sumitomo Ele**
**Ind. Ltd., 1-1 Koyakita 1-chome**
**Itami-shi, Hyogo(JP)**
Inventor: **Yazu, Shuji, c/o Itami Works of Sumitomo Ele**
**Ind. Ltd., 1-1 Koyakita 1-chome**
**Itami-shi, Hyogo(JP)**

(74) Representative: **Le Brusque, Maurice et al**
**Cabinet Harlé et Phélip 21, rue de la Rochefoucauld**
**F-75009 Paris(FR)**

(54) **Tunnel junction device using compound oxide superconductor material.**

(57) A tunnel junction device includes a pair of superconduction layers formed of a compound oxide superconductor material and an non-superconduction layer formed between the pair of superconduction layers. A c-axis of an oxide crystal of each of the pair of superconductive layers is oriented in parallel to the surface of the substrate.

## FIGURE 2

EP 0 427 640 A1

# BACKGROUND OF THE INVENTION

Field of the invention

The present invention relates to a tunnel junction device composed of compound oxide superconductor materials, and more specifically to a novel tunnel junction structure effectively used in devices including an element composed of compound oxide superconductor materials, and effectively used for constructing a circuit including an element composed of compound oxide superconductor materials.

Description of related art

In one field of superconduction application, there has been a technique utilizing a tunnel junction composed of a pair of superconduction layers and a non-superconduction layer sandwiched between the pair of superconduction layers. The tunnel junction represents a non-linear current/voltage characteristics reflecting a superconduction energy gap of the superconduction material. This tunnel junction has been now utilized in sensors such as SQIID and in switching elements such as Josephson devices.

Ordinarily, the tunnel junction used in the above mentioned elements has been composed of a pair of superconduction layers formed on a substrate, and a non-superconduction layer formed between the pair of superconduction layers. Each of the pair of superconduction layers can be formed of any superconduction material, and the non-superconduction layer can be formed of any material other than a superconduction material. Therefore, the layer sandwiched between the pair of superconduction layers is called the "non-superconduction layer" as a matter of convenience in this specification. In the case of superconduction tunnel junction, the non-superconduction layer can be formed of a normal conduction material. In fact, it has been, in many cases, formed of an Au (gold), taking into consideration an influence against the adjacent superconduction layers.

On the other hand, the superconduction layer has been conventionally constituted of a metal type superconduction material such as Nb, NbN, Pb and others. However, since Bednorz and Müller discovered an oxide superconduction material having an extremely high critical temperature in 1986, many attempts have been made to fabricate tunnel junction devices composed of oxide superconduction materials. In general, a thin film of oxide superconduction materials is very critical in a fabrication condition, and in addition, a fabricated thin film is apt to easily cause change of its properties under reduction atmosphere. Because of these and other reasons, a practical fine working of the oxide superconduction material has not yet been established.

It has been known than an oxide superconduction material has a coherence length which is one-tenth or less of that of a metal type superconduction material. Therefore, in the case of fabricating the tunnel junction by using the compound oxide superconductor materials, it is necessary to very sharply form or finish a boundary between each superconduction layer and the non-superconduction layer. However, a report that a tunnel effect element has actually been formed of an oxide superconduction material has not yet become aware of.

Summary of the Invention

Accordingly, it is an object of the present invention to provide novel structure for a tunnel junction device composed of compound oxide superconductor material, which can been certainly fabricated by overcoming the above mentioned defect of the conventional one.

According to the present invention, there is provided a tunnel junction device including a substrate, a first superconductor layer of a compound oxide superconductor material formed on a surface of the substrate, a non-superconductive material layer formed on the first superconductor layer, and a second superconductor layer of a compound oxide superconductor material formed on the non-superconductive layer, wherein a c-axis of an oxide crystal of each of the first and second superconductive layers is oriented in parallel to the surface of the substrate.

As seen from the above, the tunnel junction device in accordance with the present invention has a structure in which the first superconductor layer, the non-superconductive material layer, and the second superconductor layer are stacked on the substrate in the named order, and is characterized in that the c-axis of an oxide crystal of each of the first and second superconductive layers is oriented in parallel to a surface of the substrate.

Therefore, the tunnel junction of the stacked structure can be formed, without using a fine working technique, by sequentially depositing on the substrate, a first superconductor layer to be formed directly on a surface of the substrate, a non-superconductive material layer to be formed on the first superconductor layer, and a second superconductor layer to be formed on the non-superconductive layer, in the named order.

It has been known that, general oxide superconduction materials have remarkable anisotropy due to a crystal structure. For example, in typical Y-Ba-Cu-O type compound oxide superconductor materials, it has been known that a critical current density in a direction of a c-axis of the crystal is extremely lower than a c-plate critical current density. Therefore, it has been an ordinary practice to deposit an oxide superconductor thin film on a substrate in such a manner that the c-axis of the deposited oxide superconductor material is oriented perpendicularly to a deposition surface of the substrate.

However, considering the above mentioned stacked structure of tunnel junction device, an electric current will flow perpendicularly to the surface of the substrate. Therefore, an ordinary c-axis orientation superconduction thin film needs to form a non-practical, extremely thin layer of non-superconduction material, since the coherent length in the c-axis direction is short. Because of this reason, a tunnel junction device composed of oxide superconduction material has been reduced in practice.

On the other hand, the tunnel junction device in accordance with the present invention is such that the c-axis of the oxide superconduction material of each oxide superconduction layer is oriented in parallel to the surface of the substrate. Therefore, a large critical electric current density can be ensured in a direction perpendicular to the substrate surface. In addition, since the coherent length in a direction other than the c-axis direction is longer than that of the c-axis direction, a tunnel junction device can be formed by using a non-superconduction layer having a thickness corresponding to a long coherent length. In other words, the tunnel junction device in accordance with the present invention can have a non-superconduction layer having a thickness larger than that of the conventional one. This is very effective in a fine working process such as an etching performed after deposition of a pair of superconduction layers and an intermediate non-superconduction layer, since a thick non-superconduction layer can give tolerance in a working or etching control in a thickness of depth direction.

For example, the oxide superconduction layer having the c-axis in parallel to the substrate can be formed of an oxide superconduction layer having an a-axis perpendicular to the substrate. The oxide superconduction layer can be deposited by using, for example, a (100) surface of a MgO single crystal substrate as a deposition surface on which the oxide supercondition layer is deposited. In addition, the oxide supercondition layer having the c-axis in parallel to the substrate can be preferably deposited by maintaining a substrate at a temperature which is lower than a substrate temperature which enables a deposited layer to have a c-axis perpendicular to the substrate, by a temperature difference within a range of $10°C$ to $100°C$, and more preferably, a range of a few tons $°C$ to $100°C$.

The above mentioned tunnel junction device in accordance with the present invention can be preferably formed by using the following materials:

A preferred substrate on which the above mentioned tunnel junction device is formed, includes a MgO single crystal, a $SrTiO_3$ single crystal, a $LaAlO_3$ single crystal, a $LaGaO_3$ single crystal, a $Al_2O_3$ single crystal, and a $ZrO_2$ single crystal.

The superconductor material used in the tunnel junction device in accordance with the present invention can be of any known oxide superconduction material having anisotropy in a crystal structure. For example, the oxide superconduction material includes a La-Sr-Cu-O type oxide superconduction material, a Y-Ba-Cu-O type oxide superconduction material, a so-called Bi type oxide superconduction material, a so-called Tl type oxide superconduction material, and others.

The thickness of the superconduction layers is preferably on the order of $500Å$ to $4,000Å$, and the thickness of the non-superconduction layer is on the order of $100Å$ to $700Å$.

The compound oxide layers of the above mentioned tunnel junction device can be formed by a physical deposition or a chemical deposition, both of which are well known to persons skilled in the art. In particular, a sputtering or an ion plating can be advantageously utilized.

The above exemplified compound oxide superconduction materials can have a specific crystal structure exerting an effective superconduction property, if they are formed in a specific composition under a specific fabrication condition. However, if a content of oxygen becomes apart from the specific composition, a superconduction property will be lost or a superconduction critical current will remarkably decrease. Therefore, the compound oxide having a deteriorated superconduction property can be used as a non-superconduction layer in tunnel junction devices.

The superconductor material used in the tunnel junction device in accordance with the present invention is not limited to the above exemplified compound oxide materials. It should be understood that, any oxide superconduction material, in which a coherent length in a direction perpendicular to a c-axis direction is longer than that in a direction in parallel to the c-axis direction, can be used as the superconductor material of the tunnel junction device in accordance with the present invention.

The above and other objects, features and advantages of the present invention will be apparent from the following description of a preferred embodiment of the invention with reference to the accompanying drawings. However, it should be noted that the following disclosure is merely one embodiment for making it easier to understand the present invention, and the present invention is in no way limited to the details of the illustrated structures.

## Brief Description of the Drawings

Figure 1 is a sectional view diagrammatically illustrating a tunnel junction structure in accordance with the present invention; and

Figure 2 is a diagrammatically perspective view of an embodiment of the tunnel junction device in accordance with the present invention.

## Description of the Preferred embodiment

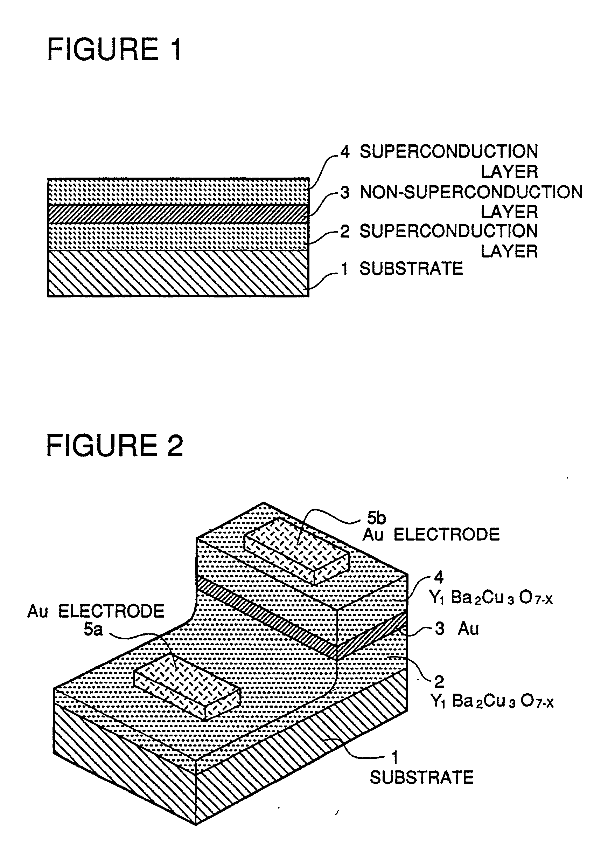

Referring to Figure 1, a tunnel junction structure in accordance with the present invention is diagrammatically illustrated. As shown in Figure 1, the tunnel junction structure is formed of a first superconduction layer 2, a non-superconduction layer 3 and a second superconduction layer 4 stacked in the named order on a substrate 1.

If the tunnel junction structure is realized in the form of a tunnel junction Josephson device, the non-superconduction layer 3 and the superconduction layer 4 are partially cut out so as to expose a portion of the superconduction layer 2, as shown a diagrammatically perspective view of Figure 2, and a pair of electrodes 5a and 5b are formed on the exposed portion of the superconduction layer 2 and the remaining superconduction layer 4.

For example, each of the superconduction layers 2 and 4 is formed of $YBa_2Cu_3O_y$, and has a thickness on the order of 500Å to 4,000Å. On the other hand, the non-superconduction layer 3 is formed of Au (gold) and has a thickness on the order of 600Å. Thus, the superconduction layer 2, the non-superconduction layer 3 and the superconduction layer 4 form a SNS Josephson junction structure.

The tunnel junction device having the structure as mentioned above and composed of Y-Ba-Cu-O type compound oxide superconduction material was fabricated in the following manner, by a RF magnetron sputtering.

Powder of $Y_2O_3$, powder of $BaCO_3$ and powder of CuO, all of are commercially available, were mixed together so as to have an atomic ratio of Y:Ba:Cu = 1.0:2.0:4.0, and a target was prepared by sintering the power mixture at 920 °C for 8 hours. The target thus prepared was used as a target of the RF magnetron sputtering for formation of each superconduction layer. On the other hand, the non-superconduction layer was formed by evaporating an Au layer having a thickness of 600Å.

A deposition condition for each superconduction layer is as follows:

| | |
|---|---|
| Substrate | : (100) plane of MgO single crystal |
| Sputtering gas | : Mixed gas of Ar and $O_2$ ($O_2$/Ar + $O_2$) = 0.2 (volume ratio) |
| Sputtering pressure | : $4 \times 10^{-2}$ Torr |
| Substrate temperature | : 650 °C |
| RF power | : 50W (0.64W/cm²) |

The thin film formed under the above mentioned condition has a composition of $YBa_2Cu_3O_y$ ($6<y\leq7$) and its a-axis oriented perpendicularly to the deposition surface of the substrate. In addition, in the course of the above deposition process, it was confirmed by an X-ray diffractometry that the lower $YBa_2Cu_3O_y$ layer deposited on the substrate has the a-axis oriented perpendicularly to the deposition surface of the substrate (namely, a c-axis in parallel to the substrate) and the upper $YBa_2Cu_3O_y$ layer deposited on the Au layer has the a-axis oriented perpendicularly to the deposition surface of the substrate. Ten tunnel junction devices having the above mentioned structure were fabricated, and a Josephson tunnel current density Ic was measured in each of the ten tunnel junction devices at a liquid nitrogen temperature (77.3K).

For comparison, second ten tunnel junction devices having the same composition oxide superconduction layers as those of the first ten tunnel junction devices were fabricated, by changing the substrate temperature and others as follows, so that the c-axis is oriented perpendicularly to the deposition surface of the substrate.

| | |
|---|---|
| Substrate | : (100) plane of MgO single crystal |
| Sputtering pressure | : $2 \times 10^{-2}$ Torr |
| Substrate temperature | : $750°$ C |
| (The other conditions are the same as those for the first ten tunnel junction devices) | |

In the course of the above deposition process, it was confirmed by an X-ray diffractometry that the lower $YBa_2Cu_3Oy$ layer deposited on the substrate has a c-axis perpendicular to the substrate and the upper $YBa_2Cu_3Oy$ layer deposited on the Au layer has a c-axis perpendicular to the substrate. A Josephson tunnel current density Ic was similarly measured for the second ten tunnel junction devices at a liquid nitrogen temperature (77.3K).

The measured Josephson tunnel currents of the first and second ten samples were compared. The measured Josephson tunnel current densities of the first ten samples having the a-axis oriented perpendicularly to the deposition surface of the substrate had a dispersion or variation of ±10%, while the measured Josephson tunnel current densities of the second ten samples having the c-axis oriented perpendicularly to the deposition surface of the substrate had a dispersion or variation of ±30%.

As seen from the above, the tunnel junction device in accordance with the present invention is characterized in that a c-axis of a crystal of each oxide superconduction material layer is oriented in parallel to substrate, and therefore, a tunnel junction device can be formed to have a good characteristics by utilizing a long coherence length (in a thickness direction) of each oxide superconduction material layer having the a c-axis oriented in parallel to substrate.

The tunnel junction device in accordance with the present invention can be realized in the form of a discrete tunnel effect element, but also can be assembled within another element or in an integrated circuit, by utilizing a known working process.

The invention has thus been shown and described with reference to the specific embodiment. However, it should be noted that the present invention is in no way limited to the details of the illustrated structures but changes and modifications may be made within the scope of the appended claims.

## Claims

1. A tunnel junction device including a substrate, a first superconduction layer of a compound oxide superconductor material formed on a surface of said substrate, a non-superconductive material layer formed on said first superconduction layer, and a second superconduction layer of a compound oxide superconductor material formed on said non-superconductive layer, wherein a c-axis of an oxide crystal of each of said first and second superconductive layers is oriented in parallel to said surface of said substrate.

2. A tunnel junction device claimed in Claim 1 wherein each of said first and second superconduction layers is formed of $YBa_2Cu_3Oy$ ($6 < y \leq 7$) and said non-superconduction layer is formed of Au.

3. A tunnel junction type Josephson device claimed in Claim 2 wherein said Au layer has the thickness of 600Å.

4. A tunnel junction type Josephson device claimed in Claim 1 wherein each of said pair of superconduction layers has a thickness within a range of 500Å to 4,000Å, said non-superconductive material layer has a thickness within a range of 100Å to 700Å

5. A tunnel junction type Josephson device claimed in Claim 1 wherein said first superconduction layer is formed on a single crystal substrate selected from a group consisting of a MgO single crystal, a $SrTiO_3$ single crystal, a $LaAlO_3$ single crystal, a $LaGaO_3$ single crystal, a $Al_2O_3$ single crystal, and a $ZrO_2$ single crystal.

6. A tunnel junction device claimed in Claim 4 wherein each of said first superconduction layer is deposited on a (100) plane surface of a MgO single crystal substrate.

7. A method for fabricating a tunnel junction device including first and second superconduction layers formed of a compound oxide superconductor material and an non-superconduction layer formed between said first and second superconduction layers, comprising the steps of depositing on a substrate said first superconduction layer by a physical deposition using a target having a composition enabling to form a deposited layer having superconductivity, and under a deposition condition for causing a c-axis of said deposited layer to be oriented in parallel to said substrate, depositing said non-superconduction layer on said first superconduction layer, and depositing on said non-superconduction layer said second superconduction layer by a physical deposition using a target having a composition enabling to form a deposited layer having superconductivity, and under a deposition condition for causing a c-axis of said deposited layer to be oriented in parallel to said substrate.

8. A method claimed in Claim 7 wherein each of said first and second superconduction layers is formed by a physical deposition while maintaining said substrate at a temperature which is lower than, by a temperature difference within a range of $10\,^{\circ}C$ to $100\,^{\circ}C$, a temperature which enables a deposited layer to have a c-axis perpendicular to the substrate.

9. A method claimed in Claim 7 wherein each of said first and second superconduction layers is formed by a physical deposition using a target composed of a powdered carbonate of Ba and a powdered oxide of each of Y and Cu mixed with a proportion which allows a deposited layer to have a composition of $YBa_2Cu_3O_y$ ($6<y\leq7$) and said non-superconduction layer is formed by evaporation of Au.

# FIGURE 1

4 SUPERCONDUCTION LAYER

3 NON-SUPERCONDUCTION LAYER

2 SUPERCONDUCTION LAYER

1 SUBSTRATE

# FIGURE 2

5b Au ELECTRODE

4 $Y_1 Ba_2 Cu_3 O_{7-x}$

Au ELECTRODE 5a

3 Au

2 $Y_1 Ba_2 Cu_3 O_{7-x}$

1 SUBSTRATE

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | APPLIED PHYSICS LETTERS, vol. 55, no. 19, 6th November 1989, pages 2032-2034, New York, US; C.T. ROGERS et al.: "Fabrication of heteroepitaxial YBa2Cu307-x-PrBa2Cu307-x-YBa2-Cu307-x Josephson devices grown by laser deposition" * Page 2032, paragraphs 2-5, figure 1 * | 1,5-8 | H 01 L 39/22 H 01 L 39/24 |
| X | EP-A-0 329 507 (THOMSON) * Column 1, lines 21-63; column 2, lines 28-41; column 6, claims 1-2; figure 4 * | 1-4,7 | |
| A | APPLIED PHYSICS LETTERS, vol. 54, no. 15, 10th April 1989, pages 1477-1479, New York, US; J. MORELAND et al.: "Evidence for the superconducting proximity effect in junctions between the surface of YBa2Cu30x thin films" * Page 1477, paragraphs 1,3-4, figure 1 * | 1-8 | |
| P,X | EP-A-0 384 521 (PHILIPS) * Column 3, lines 15-58; column 4, lines 1-12; column 5, claim 1; figure 1c * | 1-2,5-7 | |

TECHNICAL FIELDS
SEARCHED (Int. Cl.5)

H 01 L 39

The present search report has been drawn up for all claims

| Place of search | Date of completion of search | Examiner |
|---|---|---|
| The Hague | 10 January 91 | HAMMEL E.J. |

CATEGORY OF CITED DOCUMENTS

X : particularly relevant if taken alone
Y : particularly relevant if combined with another document of the same catagory
A : technological background
O : non-written disclosure
P : intermediate document
T : theory or principle underlying the invention

E : earlier patent document, but published on, or after the filing date
D : document cited in the application
L : document cited for other reasons

&: member of the same patent family, corresponding document